Europäisches Patentamt

(19) European Patent Office

Office européen des brevets

(11) **EP 1 516 193 B1**

(12) **EUROPÄISCHE PATENTSCHRIFT**

(45) Veröffentlichungstag und Bekanntmachung des Hinweises auf die Patenterteilung:
**02.11.2005 Patentblatt 2005/44**

(51) Int Cl.⁷: **G01R 31/08**

(21) Anmeldenummer: 03732558.6

(86) Internationale Anmeldenummer:
**PCT/EP2003/006071**

(22) Anmeldetag: **10.06.2003**

(87) Internationale Veröffentlichungsnummer:
**WO 2004/003578 (08.01.2004 Gazette 2004/02)**

(54) **VERFAHREN ZUR BESTIMMUNG EINES PARAMETERS EINES ELEKTRISCHEN NETZES**

METHOD FOR DETERMINATION OF A PARAMETER OF AN ELECTRICAL NETWORK

PROCEDE POUR DETERMINER UN PARAMETRE D'UN RESEAU ELECTRIQUE

(84) Benannte Vertragsstaaten:
**AT BE BG CH CY CZ DE DK EE ES FI FR GB GR HU IE IT LI LU MC NL PT RO SE SI SK TR**

(30) Priorität: **26.06.2002 AT 9572002**

(43) Veröffentlichungstag der Anmeldung:
**23.03.2005 Patentblatt 2005/12**

(73) Patentinhaber: **Adaptive Regelsysteme Gesellschaft mbH**
**5020 Salzburg (AT)**

(72) Erfinder: **LEIKERMOSER, Albert**
**A-5020 Salzburg (AT)**

(74) Vertreter: **VA TECH Patente GmbH & Co**
**Penzinger Strasse 76**
**1141 Wien (AT)**

(56) Entgegenhaltungen:
**WO-A-02/15355      US-A- 4 063 166**
**US-A- 4 568 872      US-A- 5 825 189**

**Beschreibung**

Die gegenständliche Erfindung betrifft ein Verfahren zur Bestimmung mindestens eines Parameters eines elektrischen Netzes oder eines Nullsystems des elektrischen Netzes oder eines Leitungsabschnittes oder Leitungsabzweiges des elektrischen Netzes, insbesondere der Nulladmittanz $Y$, der Phasensumme der Leitwerte der ohmschen Ableitungen $g$ und/oder der Phasensumme der Ableitkapazitäten $C$ sowie des Unsymmetriestroms $i_v$, wobei in einen Netzsternpunkt oder in das Nullsystem des elektrischen Netzes, vorzugsweise eines elektrischen Netzes mit induktiv oder über ohmschen Widerstand geerdetem oder isoliertem Sternpunkt, zumindest zeitweise ein Hilfssignal mit einer Kreisfrequenz $\omega_i$ ungleich der Netzkreisfrequenz $\omega_N$ und ungleich deren ganzzahlig ungeradzahligen Vielfachen eingespeist wird.

Wie aus der Literatur bekannt, führen mittel- bis niederohmige Erdfehler im stempunktkompensierten Netz zu einem starken Anstieg der Amplitude des netzfrequenten Anteiles der Sternpunkt-Venagerungsspannung. Diese Tatsache wird üblicherweise dazu benützt, das Vorhandensein von Erdfehlern zu erkennen. Bei höher- bis hochohmigen Erdfehlern, im Bereich von einigen zehn Kiloohm aufwärts, wie sie zum Beispiel durch das Berühren einer Phasenleitung mit dem Ast eines Baumes entstehen können, liegen die Fehlerströme größenmäßig im Bereich der Unsymmetrieströme des Netzes. Dies kann dazu führen, dass die Amplitude des netzfrequenten Anteiles der Sternpunkt-Verlagerungsspannung beim Eintritt von derartig hochohmigen Erdfehlern sogar sinkt, anstatt, wie dies bei niederohmigeren Erdfehlern der Fall ist, anzusteigen. Zusätzlich ist auch festzustellen, dass übliche Fehlererkennungseinrichtungen in sternpunktkompensierten Netzen, wie z.B. ein Schutzrelais, aufgrund der Kleinheit der Messsignale bei hochohmigen Erdfehlern erfahrungsgemäß unsicher funktionieren, sodass in solchen Situationen auf diesem Wege keine zuverlässige Information über das Vorliegen eines Erdfehlers im Netz abgeleitet werden kann.

Ferner ist zu bedenken, dass der netzfrequente Anteil der Sternpunkt-Verlagerungsspannung allein schon wegen der schwankenden Unsymmetrieströme ebenfalls zeitlichen Änderungen unterliegt. Zusätzlich ist zu berücksichtigen, dass sich die ohmschen Ableitungen des Netzes aufgrund von klimatischen Veränderungen ebenfalls stark ändern können. Also bedarf es neuer Methoden zur Erkennung der Fehlerhaftigkeit des stempunktkompensierten Netzes speziell im Zusammenhang mit hochohmigen Erdfehlern.

In der WO 02/15355 ist beispielsweise ein Verfahren zur Ortung von hochohmigen Erdfehlern offenbart, wobei ein Signal mit Netzkreisfrequenz in das Nullsystem des Netzes derart eingespeist wird, dass die Sternpunkt-Verlagerungsspannung kompensiert wird. Das Erkennen eines Erdfehlers erfolgt dann direkt anhand des Betrages des eingespeisten Hilfssignals bei Netzkreisfrequenz. Bei diesem Verfahren wird ein weiteres Hilfssignal ungleich der Netzkreisfrequenz eingespeist, wobei dieses Signal lediglich zur Abstimmung der Löschspule verwendet wird. Sowohl die Ortung von Erdfehlern, als auch das Abstimmen der Löschspule erfolgt bei diesem Verfahren bei kompensierter Sternpunkt-Verlagerungsspannung. Zur Erkennung eines Erdfehlers ist in der WO 02/15355 also notwendig, zumindest ein Hilfssignal nach Betrag und Phase zu regeln, um die Sternpunkt-Verlagerungsspannung zu kompensieren, da nur dann ein zuverlässiges Orten von Erdfehlern mit diesem Verfahren möglich ist. Eine solche Regelung ist jedoch in der Praxis aufwendig.

Die gegenständliche Erfindung stellt sich daher die Aufgabe, ein einfach umsetzbares Verfahren zur Bestimmung von Parametern eines elektrischen Netzes bzw. von Leitungsabschnitten oder Leitungsabzweigen anzugeben, mittels derer in weiterer Folge eine zuverlässige Erkennung und Ortung von, im speziellen hochohmigen, Erdfehlern, Schalthandlungen bzw. eine Abstimmung einer Löschspule ermöglicht wird.

Diese Aufgabe wird erfindungsgemäß dadurch gelöst, dass zumindest ein Parameter aus dem Nullstrom $i_0$ und der Verlagerungsspannung $U_{ne}$ bezüglich der gewählten Einspeisekreisfrequenz $\omega_i$ ermittelt wird.

Die Parameter, speziell jene des Nullsystems des betrachteten Leitungsabschnittes, können damit auf sehr einfachem Wege ermittelt werden, wobei an den Betrag und den Phasenbezug des Einspeisesignals im Wesentlichen keinerlei Anforderungen gestellt werden.

Als weiterer wichtiger Parameter eines elektrischen Netzes oder eines Leitungsabschnittes wird vorteilhafter Weise der sogenannte Unsymmetriestrom $i_v$ bezüglich der Netzkreisfrequenz $\omega_N$ ermittelt, der in Folge für weitere Auswertungen herangezogen werden kann.

Diese Parameter werden in günstiger Weise zumindest für eine Anzahl der (n) Leitungsabschnitte bzw. Leitungsabzweige eines elektrischen Netzes und/oder für das Gesamtnetz ermittelt. Die Ermittlung der Parameter des Nullsystems für das Gesamtnetz erfolgt dabei entweder über Aufsummieren der einzelnen Abzweigparameter oder alternativ durch Berechnung anhand des Summennullstromes.

Das erfindungsgemäße Verfahren ermöglicht es somit, wichtige Parameter des elektrischen Versorgungsnetzes auf sehr einfache Art und Weise zu ermitteln, die dann für weitere Auswertungen herangezogen oder zur Ermittlung weiterer wichtiger Kenngrößen des Netzes, wie des Wattreststromes oder des Spulenresonanzstromes, verwendet werden.

Besonders vorteilhaft werden die ermittelten Parameter zur Ortung von Erdfehlern herangezogen, wobei ein Erdfehler dann erkannt und gegebenenfalls angezeigt wird, wenn der Realteil bzw. die Realteiländerung der Nulladmittanz $Y$ für eine vorgegebene Zeitspanne eine vorgegebene Fehlerschwelle überschreitet. Ein Erdfehler kann also anhand der sehr einfach ermittelten Parameter des Netzes erkannt werden, wodurch die Erdfehlererkennung ausgesprochen einfach und trotzdem zuverlässig vorgenommen werden kann.

Darüber hinaus kann auch eine Schalthandlung im Gesamtnetz oder innerhalb eines Leitungsabschnittes bzw. -abzweiges sehr einfach anhand der ermittelten Parameter erkannt und gegebenenfalls angezeigt werden, indem der Imaginärteil bzw. die Imaginärteiländerung der Nulladmittanz $Y$ mit einer Fehlerschwelle verglichen wird. Damit wird ausgeschlossen, dass eine Schalthandlung irrtümlich als Erdfehler angezeigt wird.

Ein einfach umsetzbares Verfahren erhält man, wenn man im Falle eines Erdfehlers die unmittelbar vor Eintritt des Erdfehlers ermittelten Parameter des Nullsystemes des betrachteten Leitungsstückes zur Auswertung des Fehlerzustandes heranzieht. Damit gelingt es auch, die fehlerhafte Phase einfach zu detektieren.

Zur Umsetzung des Verfahrens wird in vorteilhafter Weise ein nichtnetzfrequenter Spektralanteil der Fourier-Transformierten des Nullstromes $i_0$ des betrachteten Leitungsabschnittes bzw. -abzweiges bzw. des Summennull-stroms $i_{0S}$ und der entsprechende nichtnetzfrequente Spektralanteil der Fourier-Transformierten der Verlagerungsspannung $U_{ne}$ bestimmt und der Berechnung zugeführt. Vielfach werden diese Signale in bestehenden elektrischen Anlagen bereits gemessen, sodass diese Messwerte direkt zur Auswertung herangezogen werden können.

Um die weitere Verarbeitung zu vereinfachen, werden die Momentanwerte des Nullstromes $i_0$ des Leitungs-abschnittes bzw. -abzweiges bzw. des Summennullstroms $i_{0S}$ und der Verlagerungsspannung $U_{ne}$ zu zeitlich äquidistanten Zeitpunkten abgetastet und in digitaler Form in einem digitalen Speicher abgelegt. Damit kann die Auswertung, beispielsweise durch numerische Verfahren, in digitaler Form, z.B. auf einem Computer erfolgen, was die Flexibilität dieses Verfahren erheblich erhöht.

In günstiger Weise werden für jede Messgröße zu zeitlich äquidistanten Zeitpunkten eine Folge mit vorgegebener Anzahl N von aufeinanderfolgenden Momentanwerten dieser Messgröße mit einem Analog - Digitalwandler gemessen und digitalisiert, dann abgespeichert und die Auswertung anhand dieser Messwertfolgen durchgeführt. Die eigentliche Auswertung der Messwerte erfolgt vorteilhaft mit der Fast (FFT) oder der diskreten (DFT) Fourier Transformation.

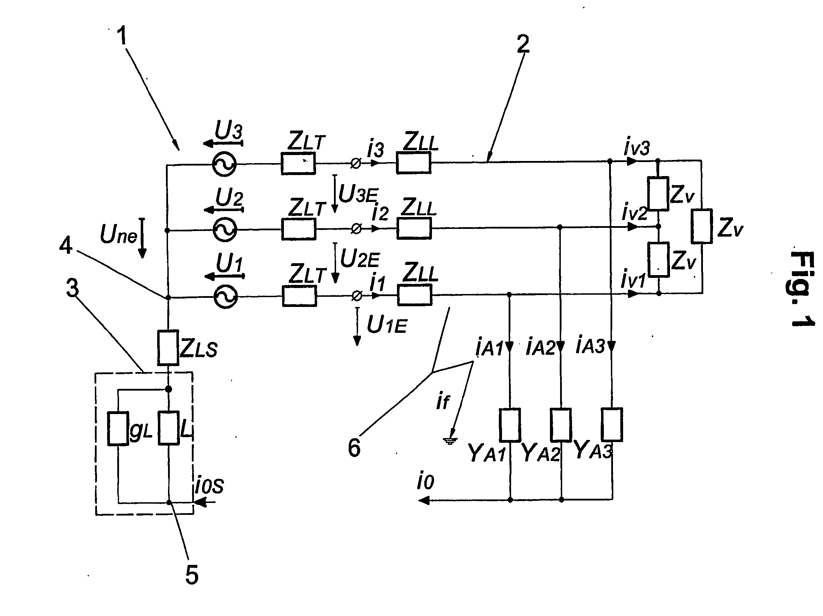

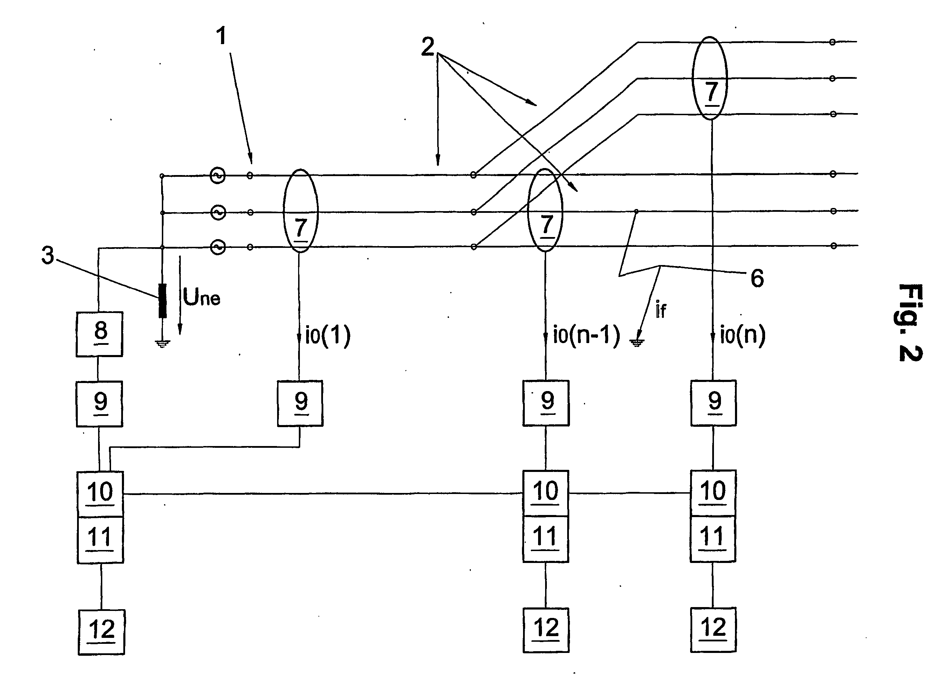

Die Erfindung wird anhand der folgenden Erläuterungen unter Bezugnahme auf die begleitenden beispielhaften und schematischen Zeichnungen Fig. 1 und Fig. 2 näher beschrieben. In den Zeichnungen zeigt

Fig. 1 das elektrische Ersatzschaltbild des Nullsystems eines Abzweiges eines stempunktkompensierten Netzes mit induktiver Sternpunkterdung und

Fig. 2 eine beispielhafte Anordnung zur Bestimmung der Parameter des Netzes.

In Fig. 1 ist das bekannte elektrische Ersatzschaltbild eines Leitungsabschnittes eines elektrischen Versorgungsnetzes 1 dargestellt. Zwischen dem Transformatorstempunkt 4 und dem Erdungspunkt 5 befindet sich beispielhaft eine Löschspule 3, die durch einen ohmschen Leitwert $g_L$ und eine Induktivität $L$ beschrieben wird. Wird das Netz widerstandsgeerdet betrieben, so wird der Erdungswiderstand durch den Leitwert g repräsentiert, während die Induktivität $L$ entfällt. Die Streuinduktivitäten sowie die ohmschen Widerstände der Sekundärwicklung des Speisetransformators werden durch die für alle drei Phasen als gleich groß angenommenen Längsimpedanzen $Z_{LT}$ repräsentiert. In das Netz, hier bestehend aus nur einem Leitungsabschnitt, werden die Phasenspannungen $U_1$, $U_2$ und $U_3$ eingespeist und es fließen die Phasenströme $i_1$, $i_2$ und $i_3$. Zwischen den drei Phasen und der Erde liegen die Phasen-Erdspan-nungen $U_{1E}$, $U_{2E}$ und $U_{3E}$ an.
Ein Leitungsabschnitt wird, wie für den betrachteten Frequenzbereich von <100Hz zulässig, durch Leitungslängsimpedanzen $Z_{LL}$, bestehend aus einem ohmschen und einem induktiven Term, und Leitungsableitadmittanzen $Y_{A1}$, $Y_{A2}$ und $Y_{A3}$, bestehend aus einer ohmschen und einer kapazitiven Komponente , beschrieben. Über die Leitungsableit-admittanzen $Y_{A1}$, $Y_{A2}$ und $Y_{A3}$ fließen die Ableitströme $i_{A1}$, $i_{A2}$ und $i_{A3}$. Die Ableitströme $i_{A1}$, $i_{A2}$ und $i_{A3}$ fließen als Nullstrom $i_0$ dieses Leitungsabschnittes über die Löschspule 3 zum Transformatorstempunkt 4 zurück. Am Erdungspunkt der Löschspule 3 vereinigen sich die Nullströme $i_0$ aller vorhandenen Leitungsabschnitte 2 zur Summe der Nullströme $i_{0S}$. Verbraucherseitig, repräsentiert durch Verbraucherimpedanzen $Z_V$, fließen die Verbraucherströme $i_{V1}$, $i_{V2}$ und $i_{V3}$.

Dieses Ersatzschaltbild wird zur Herleitung von für das erfindungsgemäße Verfahren wichtigen Beziehungen verwendet.
Zu den folgenden Erläuterungen sei vorab angemerkt, dass sich die nachfolgenden Formeln, wenn nicht anders angemerkt, auf die Laplacetransformierten der jeweiligen elektrischen Größen beziehen, die vorkommenden elektrischen Größen zwecks Vereinfachung der Schreibweise jedoch nicht explizit als Funktion der komplexen Frequenzvariablen $s$ geschrieben werden, also wird beispielsweise $U_{ne}(s)$ mit $U_{ne}$ bezeichnet.

Wie aus dem elektrischen Ersatzschaltbild gemäß Fig. 1 entnommen werden kann, ergibt sich der Nullstrom $i_0$, also die arithmetische Summe der einzelnen Phasenströme, eines beliebigen (n)-ten Leitungsabzweiges bzw. -abschnittes 2 als sehr gute Näherung aus der Beziehung

$$i_0 = U_{ne} \cdot Y + i_v + i_f,$$

mit der Nulladmittanz, bzw. gleichwertig auch als Erdadmittanz bezeichnet,
$Y = (Y_{A1} + Y_{A2} + Y_{A3})$ und dem Unsymmetriestrom, bzw. Verlagerungsstrom,
$i_v = (U_1 \cdot \Delta Y_{A1} + U_2 \cdot \Delta Y_{A2} + U_3 \cdot \Delta Y_{A3})$, wobei die $\Delta Y_{Ai}$ die Unsymmetrie der Nulladmittanzen beschreiben, und dem im Fehlerfall vorhandenen Fehlerstrom $i_f$.

Der Term Y repräsentiert die Phasensumme der Ableitadmittanzen $Y = (Y_{A1} + Y_{A2} + Y_{A3})$ der drei Phasen, wobei sich die einzelnen Ableitadmittanzen aus einem resistiven g und einem kapazitiven Term C zusammensetzen, für den (n)-ten Leitungsabschnitt wird die Nulladmittanz Y mit Y(n) bezeichnet.

Betrachtet man die obigen Beziehungen für den Unsymmetriestrom $i_v$ spektral, also $i_v(j\overline{\omega})$, so kann z.B. aufgrund einer Fourierreihenzerlegung der Phasenspannungen direkt daraus gefolgert werden, dass der Spektralanteil des Unsymmetriestromes $i_v(j\overline{\omega})$ für Kreisfrequenzen ungleich der Netzkreisfrequenz $\omega_N$ und deren ganzzahlig ungeradzahligen Vielfachen Null sein muss, also unberücksichtigt bleiben kann.

Weiters erkennt man, dass der Unsymmetriestrom $i_v$ unabhängig vom Nullsystem und somit von der Verlagerunasspannung $U_{ne}$ ist.

Wird nun ein Signal mit eine Kreisfrequenz $\omega_i$ ungleich der Netzkreisfrequenz $\omega_N$ sowie deren ganzzahlig ungeradzahligen Vielfachen in den Netzsternpunkt bzw. in das Nullsystem eingespeist, wobei Einspeisen in das Nullsystem bedeutet, dass eine Größe, wie die Verlagerungsspannung, bezüglich Erde verändert wird, z.B. in Form eines Stromes über die Hilfswicklung der Erdschluss-Löschspule 3, kann bezüglich des (n)-ten Leitungsabschnittes oder Leitungsabzweiges 2 aus diesen Überlegungen direkt gefolgert werden:

$$i_0(n, j\overline{\omega}_i) = U_{ne}(j\overline{\omega}_i) \cdot Y(n, j\overline{\omega}_i) + i_f(j\overline{\omega}_i)$$

$$Y(n, j\omega_i) = g(n) + j\overline{\omega}_i C(n).$$

Die Abzweignulladmittanz $Y(n, j\omega_i)$ des (n)-ten Leitungsabschnittes oder Leitungsabzweiges setzt sich aus der Phasensumme der Leitwerte der ohmschen Ableitungen $g(n)$, also einem resistiven Anteil, und der Phasensumme der Ableitkapazitäten $C(n)$, also einem kapazitiven Anteil, zusammen. Ist der (n)-te Leitungsabschnitt oder Leitungsabzweig nun fehlerfrei, so reduziert sich diese Gleichung auf

$$i_0(n, j\overline{\omega}_i) = U_{ne}(j\overline{\omega}_i) \cdot Y(n, j\overline{\omega}_i),$$

woraus sich die Abzweigparameter $g(n)$ und $C(n)$ wie folgt berechnen lassen

$$g(n) = \mathrm{Re}[Y(n, j\varpi_i)] = \mathrm{Re}\left[\frac{i_0(n, j\varpi_i)}{U_{ne}(j\varpi_i)}\right],$$

$$C(n) = \frac{1}{\varpi_i}\mathrm{Im}[Y(n, j\varpi_i)] = \frac{1}{\varpi_i}\mathrm{Im}\left[\frac{i_0(n, j\varpi_i)}{U_{ne}(j\varpi_i)}\right],$$

wobei Re und Im für den Realteil und für den Imaginärteil stehen. Damit können bei Kenntnis des Nullstromes $i_0$ des Leitungsabschnittes 2 und der Verlagerungsspannung $U_{ne}$ bei der Injektionskreisfrequenz $\overline{\omega}_i$, beispielsweise bei Kenntnis von deren Spektralanteilen, die Abzweignulladmittanz $Y(n, j\omega_i)$, bzw. die Abzweigparameter $g(n)$ und $C(n)$, sehr einfach ermittelt werden. Für einen fehlerbehafteten Abschnitt folgt dann aus dem Obigen konsequenterweise

$$\mathrm{Re}[Y(n, j\overline{\omega}_i)] = g(n) + g_f.$$

Damit kann aber ein fehlerhafter Leitungsabschnitt oder Leitungsabzweig 2 sehr einfach ermittelt werden. Springt nämlich dieser Realteil plötzlich über eine vorwählbare Schwelle oder überschreitet die Differenz aus dem aktuellen Realteil und dem Wert vergangener Realteile eine andere vorwählbare Schwelle, während der Imaginärteil weitestgehend konstant bleibt, so ist der Leitungsabschnitt bzw. Leitungsabzweig 2 fehlerhaft. Ändert sich hingegen plötzlich der Imaginärteil der Ableitadmittanz, also überschreitet z.B. der Absolutbetrag der Differenz aus dem aktuellen Imaginärteil und aus vergangenen Imaginärteilen der Abschnittsnulladmittanz $Y(n,j\omega_i)$ eine gewisse vorwählbare Schwelle für eine vordefinierte Zeit, während der Realteil weitgehend konstant bleibt, so hat im überwachten Leitungsabschnitt bzw. -abzweig eine Zu- oder Abschaltung von einem oder mehreren Leitungteilen stattgefunden.

Ein dritter wichtiger Abzweigparameter eines Leitungsabzweiges bzw. -abschnittes eines elektrischen Netzes ist der Unsymmetriestrom $i_v$, der wie oben gezeigt, nur aus Spektralanteilen bezüglichen der Netzkreisfrequenz $\omega_N$ sowie deren Oberwellen besteht, und der nun mittels der beiden Abzweigparameter $g(n)$ und $C(n)$ einfach aus der Beziehung

$$i_v(n,j\overline{\omega}_N) = i_0(n,j\overline{\omega}_N) - U_{ne}(j\overline{\omega}_N) \cdot Y(n,j\overline{\omega}_N)$$

mit

$$Y(n,j\overline{\omega}_N) = g(n) + j\overline{\omega}_N C(n)$$

ermittelt werden kann. Die Verlagerungsspannung $U_{ne}$ und der Nullstrom $i_0$ des (n)-ten Leitungsabschnittes bzw. -abzweiges, könnten z.B. durch Messung gewonnen werden. Die Spektralanteile der Verlagerungsspannung $U_{ne}$ und des Nullstromes $i_0$ bezüglich der Netzkreisfrequenz $\omega_N$ des (n)-ten Leitungsabschnittes bzw. -abzweiges sind beispielsweise durch Anwendung einer Fouriertransformation, einer Fast- (FFT) oder diskreten Fouriertransformation (DFT), der Messwerte oder durch frequenzselektive Vorfilterung und nachfolgende Berechnung von Betrag und Phase der jeweiligen Messgröße oder durch andere gleichwertige Methoden im Zeit- oder Frequenzbereich ermittelbar.

Für das Gesamtnetz 1, also der Summe aller (n) Leitungsabschnitte bzw. Leitungsabzweige 2, erhält man natürlich äquivalente Beziehungen, da sich der über die Löschspule 3 rückfließende Nullstrom $i_{0S}$, der z.B. an der Hauptwicklung der Löschspule 3 gemessen werden kann, als Summe der Nullströme $i_0$ der einzelnen (n) Leitungsabschnitte bzw. Leitungsabzweige 2 ergibt, also die obigen Gleichungen für das Gesamtnetz 1 in der Form

$$i_{0S}(j\overline{\omega}_i) = U_{ne}(j\overline{\omega}_i) \cdot Y_S(j\overline{\omega}_i)_L + i_f(j\overline{\omega}_i)_\lrcorner,$$

$$i_{vS}(j\overline{\omega}_N) = i_{0S}(j\overline{\omega}_N) - U_{ne}(j\overline{\omega}_N) \cdot Y_S(j\overline{\omega}_N)$$

mit

$$Y_S(j\omega_N) = g_S + j\overline{\omega}_N C_S$$

darstellbar ist. Dabei entspricht $g_S$ der Summe der ohmschen Ableitungen und $C_S$ der Summe der Phasenerdkapazitäten, bzw. Phasenableitkapazitäten, über alle Leitungsabschnitte bzw. Leitungsabzweige des Gesamtnetzes 1 und $i_{vS}(j\overline{\omega}_N)$ dem netzfrequenten Anteil des Verlagerungsstromes vom Gesamtnetz 1.

Daraus folgt aber auch weiters, dass die Parameter $g_S$, $C_S$ und $i_{vS}(j\overline{\omega}_N)$ des Gesamtnetzes 1 entweder durch Aufsummieren der einzelnen Abzweigparameter $g(n)$, $C(n)$ und $i_v(n,j\overline{\omega}_N)$, oder durch Berechnung, wie oben gezeigt, erfolgen kann. Die Auswertung zur Bestimmung eines Erdfehlers 6 im Gesamtnetz 1 erfolgt selbstverständlich ebenfalls analog wie oben beschrieben, also durch Auswertung der Real- und Imaginärteile der Summennulladmittanz $Y_S(j\omega_i)$.

Eine geeignete Methode zu Bestimmung der Abzweigparameter $g(n)$, $C(n)$ und $i_v(n,j\overline{\omega}_N)$ bzw. der Parameter $g_S$, $C_S$ und $i_{vS}(j\overline{\omega}_N)$ des Gesamtnetzes 1 wird nun mit Hilfe der Fig. 2 näher beschrieben, wobei ausdrücklich darauf hingewiesen wird, dass diese Methode lediglich beispielhaft angeführt wird, da es, wie weiter unten angemerkt, eine Vielzahl von möglichen Verfahren zur Bestimmung dieser Parameter gibt.

Die Terme $i_0(n,j\overline{\omega}_i)$ bzw. $i_{0S}(j\overline{\omega}_i)$ und $U_{ne}(j\overline{\omega}_i)$ können beispielsweise durch Signalabtastung eines Nullstrommeßsignals mit einer geeigneten Strommesseinheit 7 und eines Sternpunkt-Verlagerungsspannungsmesssignals mit einer geeigneten Spannungsmesseinheit 8 mit einer geeigneten Abtastfrequenz, die vorteilhaft einem ganzzahligen Vielfachen der Injektionskreisfrequenz $\overline{\omega}_i$ entspricht, mit nachfolgender A/D Wandlung in einem geeigneten A/D-Wandler 9 und der Durchführung einer FFT (Fast Fourier Transformation) oder DFT (Diskreten Fourier Transformation) in einer Auswerteeinheit 10, z.B. ein Computer mit entsprechender Softwareausstattung, ermittelt werden. Die Abtastfrequenz ist dabei natürlich so zu wählen, daß die Kreisfrequenz $\bar{\omega}_i$ des Injektionssignales im diskreten Spektrum der FFT oder DFT auch enthalten ist.

Die Terme $i_0(n,j\bar{\omega}_i)$ bzw. $i_{0S}(j\bar{\omega}_i)$ und $U_{ne}(j\bar{\omega}_i)$ entsprechen dann den Spektralwerten der jeweiligen Fouriertransformierten bezüglich der Kreisfrequenz $\bar{\omega}$.. Natürlich können bei der FFT oder DFT Berechnung auch in bekannter Weise geeignete Fensterfunktionen verwendet werden. Vor der Durchführung der FFT oder DFT werden die beiden Folgen von den zu zeitlich äquidistanten Zeitpunkten ermittelten Binärwerten der beiden Messgrößen für eine gewisse, vorgegebene Anzahl N jeweils sequentiell, z.B. in einem elektronischen Speicher 11, hinterlegt. Dabei sollte man der Einfachheit halber beachten, dass die zum gleichen Zeitpunkt ermittelten Messwerte der beiden Messgrößen auch mit dem gleichen Speicherindex versehen werden, also der (k)-te Messwerteintrag des ersten Messwertspeichers zum gleichen Zeitpunkt gemessen wurde wie der (k)-te Messwerteintrag des zweiten Messwertspeichers.

Nach Beendigung eines Messzyklus, also nachdem genau N Messungen der beiden Größen erfolgt und in den zugehörigen Messwertspeichem 11 hinterlegt worden sind, werden beispielsweise mit der Fast Fourier Transformation (FFT) oder der diskreten Fouriertransformation (DFT) die diskreten Spektralanteile bezüglich Netzkreisfrequenz $\bar{\omega}_N$ und Einspeisekreisfrequenz $\bar{\omega}_i$ von den beiden, dem Abschnittnullstrom $i_0$ und der Verlagerungsspannung $U_{ne}$ zugeordneten, Messgrößen über den Messzyklus berechnet und daraus nach obigen Methoden die drei, diesem Messzyklus zugeordneten, Abzweigparameter des betrachteten (n)-ten Leitungsabschnittes bzw. Leitungsabzweiges 2 bzw. Parameter des Gesamtnetzes 1 bestimmt.

Da die Spektralanteile des Nullstromes des (n)-ten Leitungsabschnittes $i_0(n,j\bar{\omega}_N)$ und der Verlagerungsspannung $U_{ne}$ $(j\bar{\omega}_N)$ bezüglich Netzkreisfrequenz $\bar{\omega}_N$ bei der Durchführung der FFT oder DFT mitbestimmt werden, können die netzfrequenten Spektralanteile des Unsymmetriestromes $i_v(n,j\bar{\omega}_N)$ des betrachteten (n)-ten Leitungsabschnittes bzw. - abzweiges 2 ebenfalls direkt ermittelt werden.

Damit ist es nun möglich, die Fehlerfreiheit eines Netzes 1 bzw. eines Leitungsabschnittes 2 mit der weiter oben vorgestellten Auswertemethode zu überwachen und im Falle eines Erdfehlers 6 diesen an einer geeigneten Anzeigeeinrichtung 12 anzuzeigen. Dabei könnten auch gewisse Toleranzfenster eingeführt werden, sodass z.B. ein Erdfehler 6 nur dann angezeigt wird, wenn die entsprechende Fehlerbedingung für eine Anzahl von hintereinanderfolgender Messzyklen überschritten wird.

In der Anordnung nach Fig. 2 ist in jedem der n Leitungsabschnitte 2 eine Auswerteeinheit 10 mit Speicher 11 und Anzeigeeinrichtung 12 angeordnet, d.h. dass die Auswertung für jeden Leitungsabzweig 2 eigenständig durchgeführt wird. Selbstverständlich ist es auch möglich, die Auswertung zentral durchzuführen. Dabei würden die Messwerte der Abschnittnullströme $i_0$ sowie der Verlagerungsspannung $U_{ne}$ entweder in digitaler oder analoger Form zu einer zentralen Auswertung übertragen und dort entsprechend analysiert. Ein eventuell vorhandener Erdfehler 6 könnte dann an einer zentralen Stelle, z.B. einer Steuerzentrale, angezeigt werden. Natürlich ist auch eine beliebige Kombination einer verteilten und einer zentralen Auswertung möglich.

Der Austausch der digitalen oder analogen Messwerte zur Auswertung des Fehlerzustandes des Netzes 1 erfolgt, wie in Fig. 2 angedeutet, z.B. über eine Verbindung, wie z.B. eine Datenleitung, zwischen den jeweiligen Auswerteeinheiten. Wobei selbstverständliche jede beliebige Möglichkeit zum Datenaustausch, insbesondere auch kontaktlose Methoden, denkbar sind.

Bei der Durchführung dieses Verfahrens werden an die Amplitude des Einspeisesignales keine besonderen Anforderungen gestellt. Sie sollte jedoch einerseits eine zuverlässige numerische Auswertung ermöglichen, also statistisch gesehen deutlich über der "Rauschgrenze" liegen, und andererseits die vom Netzbetreiber vorgegebenen Maximalwerte bezüglich zulässiger Injektionsstromamplituden und daraus resultierender Verlagerungsspannungen $U_{ne}$ nicht überschreiten.

Die Einspeisung eines oder mehrerer Signale mit einer Frequenz ungleich der Netzkreisfrequenz $\bar{\omega}_N$ oder deren ganzzahlig ungeradzahliger Vielfacher ins Nullsystem des Netzes 1 kann kontinuierlich, mit zeitlich schwankender Amplitude oder bei Bedarf fallweise zu periodischen oder willkürlichen Zeitpunkten und mit beliebiger Einspeisedauer erfolgen. Die Abtastfrequenz wird in vorteilhafter Weise so gewählt, dass sie einem ganzzahligen Vielfachen der Netzkreisfrequenz $\bar{\omega}_N$ entspricht, und die Länge N des Messzyklus wird in vorteilhafter Weise derart gewählt, dass unter Berücksichtigung der Abtastfrequenz die resultierende Messzyklusdauer sowohl bezüglich der Netzkreisfrequenz $\bar{\omega}_N$ als auch bezüglich der Kreisfrequenz $\bar{\omega}_i$ des Einspeisesignales einer jeweils ganzzahligen Anzahl von Periodendauem dieser beiden Signale entspricht. Der Start von Messwertzyklen kann dabei zu periodischen, aperiodischen oder zu beliebigen Zeitpunkten je nach Bedarf erfolgen, wird zur Festlegung von Phasenbeziehungen aber in vorteilhafter Weise mit einem, aus einer oder mehreren Phasenspannungen gebildeten Netzreferenzsignal synchronisiert.

Die zugrundeliegende Gleichung, stellt einen Zusammenhang zwischen den Laplacetransformierten der physikalischen Größen Nullstrom $i_0$ und Verlagerungsspannung $U_{ne}$ her. Die Rücktransformation der Gleichung in den Zeitbereich liefert in bekannter Weise eine lineare Differentialgleichung, die natürlich mit hinlänglich bekannten geeigneten mathematischen Verfahren, wie z.B. analytischen oder numerischen Methoden, genauso gelöst werden könnte, wobei dann die gesuchten Abzweigparameter $g(n)$ und $C(n)$ als Koeffizienten dieser Differentialgleichung auftreten. Ferner ist auch die Anwendung der sogenannten Bilineartransformation, eines beliebigen geeigneten Verfahrens im Zeitbereich oder eine z-Transformation denkbar, die eine Lösung dieses mathematischen Problemes in äquivalenter Weise ermöglicht. Durch Anwendung von Methoden im Zeitbereich könnten die gesuchten Leitungsparameter z.B. als Ergebnis eines Parameterschätzverfahrens durch Schätzen der Koeffizienten einer den Leitungsabschnitt beschreibenden, linearen Differentialgleichung oder deren äquivalenter Differenzengleichung bestimmt werden.

Außerdem wäre es natürlich auch möglich, dass die der Einspeisesignalkreisfrequenz $\bar{\omega}_i$ zugehörigen Spektralanteile von Nullstrom $i_0$ und Verlagerungsspannung $U_{ne}$ auch durch den Einsatz frequenzselektiver Filter, z.B. auf messtechnischem Wege, gewonnen und nachfolgend entsprechend weiterverarbeitet werden.

Man erkennt daraus insbesondere, dass letztlich eine Vielzahl von Methoden in äquivalenter Weise zur Bestimmung der Abzweigparameter $g(n)$ und $C(n)$ angewandt werden können, beispielsweise Methoden im Zeitbereich, Koeffizientenschätzverfahren oder Methoden der frequenzselektiven Vorfilterung.

Neben der Bestimmung der Fehlerfreiheit bzw. Fehlerhaftigkeit des Gesamtnetzes 1 kann auch der fehlerhafte Leitungsabschnitt oder -abzweig lokalisiert werden, wie im folgenden beschrieben.

Während des fehlerfreien Netaustandes werden kontinuierlich oder bei Bedarf die netzfrequenten Anteile des Verlagerungsstromes $i_v(n, j\bar{\omega}_N)$ des (n)-ten Leitungsabschnittes, sowie die Abzweigparameter $g(n)$ und $C(n)$ ermittelt und, nach einer allfälligen Mittelung oder Filterung mit vorherigen Parametern oder Referenzwerten, z.B. in digitaler Form in einem digitalen Speicher, als Referenzwerte $i_{vREF}(n, j\bar{\omega}_N)$, $g_{REF}(n)$ und $C_{REF}(n)$ abgespeichert. Tritt nun ein Erdfehler 6 auf, so wird die Aktualisierung des Referenzwertspeichers unterbrochen, womit die vor dem Fehlereintritt ermittelten Parameter bzw. Referenzwerte als letztgültige Referenzwerte hinterlegt bleiben. Es kann davon ausgegangen werden, dass sich die im fehlerfreien Netz ermittelten Parameter bzw. Referenzwerte des betrachteten (n)-ten Leitungsabschnittes 2 nicht kurzfristig ändern, sodass es legitim ist, die tatsächlichen Leitungsabschnittsparameter zumindest für kurze Zeiträume durch die entsprechenden Referenzwerte zu ersetzen, womit die bekannte Gleichung in der Form

$$Y_{REF}(n, j\omega_N) = g_{REF}(n) + j\bar{\omega}_N C_{REF}(n)$$

geschrieben werden kann und der aktuelle Verlagerungsstrom in der Form

$$i_v(n, j\bar{\omega}_N) = i_{vREF}(n, j\bar{\omega}_N)$$

substituiert wird. Damit erhält man durch Umformen den netzfrequenten Anteil des Fehlerstromes mit

$$i_f(n, j\omega_N) = i_0(n, j\omega_N) - [U_{ne}(j\omega_N) Y_{REF}(n, j\omega_N)] - i_{vREF}(n, j\omega_N),$$

wobei die Terme $i_0(n, j\omega_N)$ und $U_{ne}(j\omega_N)$ den netzfrequenten Spektralanteilen des aktuellen Leitungsabschnittsnullstroms und der aktuellen Verlagerungsspannung entsprechen. Mit diesem Verfahren lassen sich also in direkter Weise die netzfrequenten Anteile des Fehlerstromes bestimmen. Liegt nun beispielsweise der Betrag des in komplexer Form ermittelten Fehlerstromes $i_f(n, j\omega_N)$ für eine vorgegebene Zeit über einer vorgegebenen Fehlerstromschwelle, so ist der betrachtete (n)-te Leitungsabschnitt 2 als fehlerhaft auszuweisen und eine entsprechende Fehlermeldung abzusetzen. Da der Fehlerstrom $i_f(n, j\omega_N)$ gleichphasig zur Phasen-Erdspannung der fehlerbehafteten Phase ist, kann bei Kenntnis der Phasenbeziehungen der drei Phasen-Erdspannungen bezüglich des Netzreferenzsignales durch Phasenvergleich der Phasenwinkel des Fehlerstromes $i_f(n, j\omega_N)$ mit den Phasenwinkeln der drei Phasen-Erdspannungen, z.B. in einer Auswerteeinheit 10, die fehlerbehaftete Phase ermittelt und an einer Anzeigeeinrichtung 12 geeignet angezeigt werden. Dabei wird jene Phase als fehlerhaft erklärt, deren Phasenwinkel der zugehörigen Phasen-Erdspannung am besten mit dem Phasenwinkel des Fehlerstromes, jeweils bezogen auf das Netzreferenzsignal, korreliert. Sinkt nun der Betrag des netzfrequenten Anteiles Fehlerstromes $i_f(n, j\omega_N)$ unter eine vordefinierte "fehlerfrei" Schwelle und/oder ergibt ein anderes geeignetes Verfahren den Status der Fehlerfreiheit des Netzes, so wird das oben beschriebene Verfahren zur Fehlerortung fortgesetzt, also die aktuellen Leitungsabschnittparameter, eventuell nach einer optionalen Mittelung, als Referenzwerte $i_{vREF}(n, j\omega_N)$, $g_{REF}(n)$ und $C_{REF}(n)$ im Referenzwertspeicher hinterlegt.

Aus der Summenkapazität $C_S$ könnte nun bei induktiver Sternpunkterdung mittels einer Löschspule 3 in bekannter Weise aus der Resonanzbedingung für Netzfrequenz die Induktivität L der sogenannten Löschspule 3 für Resonanz oder für eine beliebige gewünschte Verstimmung der Löschspule 3 bestimmt werden. Ist diese Löschspule 3 in ihrer Induktivität L verstellbar, so könnte deren Induktivität L dann, wenn möglich auch automatisiert, auf den ermittelten Wert eingestellt werden. Erfolgt die Einspeisung des Einspeisesignales kontinuierlich, so könnte die Richtigkeit der Abstimmung der Löschspule 3 auch kontinuierlich überwacht werden, womit eine Änderung des Netzzustandes unmittelbar erkennbar und die Löschspule 3 sofort abstimmbar wäre, sodass die gewünschte Verstimmung bezüglich der Resonanzbedingung wiederhergestellt wäre.

Die ermittelten Netzparamter könnten weiters auch noch direkt zur Ermittlung weiterer Kennwerte verwendet werden. Multipliziert man z.B. der Summenleitwert $g_S$ mit dem Effektivwert der Phasennennspannung des Netzes 1, so entspricht dieses Produkt dem sogenannten Wattreststrom, der ein wichtiger Indikator im Zusammenhang mit dem Löschverhalten des Netzes 1 und der Größe des Fehlerstromes $i_f$ ist.

Multipliziert man hingegen die Summenerdkapazität $C_S$ mit dem Effektivwert der Phasennennspannung, also mit der nicht verketteten Nennspannung des Netzes 1, und mit der Netzkreisfrequenz $\bar{\omega}_N$, so entspricht dieses Produkt dem sogenannten Spulenresonanzstrom, der für die Abstimmung der Erdschluss-Löschspule 3 auf Resonanz oder auf eine vorwählbare Verstimmung maßgebend ist. Dieser Strom entspricht dem Summenstrom der kapazitiven Ableitungen des gesamten Netzes 1, wenn der Effektivwert der Sternpunkt-Verlagerungsspannung $U_{ne}$ genau dem Effektivwert der Phasennennspannung des Netzes 1 entspricht. Diese Bedingung ist im Falle von sehr niederohmigen Erdfehlern 6 näherungsweise gegeben, woraus geschlossen werden kann, dass die Induktivität L der Erdschluss-Löschspule 3 zwecks Minimierung des Stromes an der Fehlerstelle idealerweise so abzustimmen ist, dass der durch die Erdschluss-Löschspule 3 fließende Strom bei Anliegen der Phasennennspannung ebenfalls diesem Spulenresonanzstrom entspricht.

Auf die Erzeugung und Einspeisung geeigneter Einspeisesignale wird hier nicht im Detail eingegangen. Es wird aber darauf hingewiesen, dass selbstverständlich jedes beliebige Verfahren zur Anwendung kommen kann, insbesondere ein Verfahren und eine Vorrichtung ähnlich dem wie in der WO 02/15355 offenbart.

In der obigen Beschreibung wird immer von der Einspeisung eines einzigen Signals mit einer Kreisfrequenz $\bar{\omega}_i$ ungleich der Netzkreisfrequenz $\bar{\omega}_N$ gesprochen, es ist jedoch selbstverständlich auch möglich, mehrere solcher Signale in das Nullsystem einzuspeisen und für jede dieser Kreisfrequenzen $\bar{\omega}_i$ die entsprechenden Parameter, wie oben beschrieben, zu ermitteln. Aus den einzelnen Parametern könnten dann "gemittelte Parameter" ermittelt werden und die Auswertung anhand dieser gemittelten Parameter durchgeführt werden.

Ferner können alle dargelegten Verfahren, insbesondere die der Fehlerortung, auch bei widerstandsgeerdeten Netzen, also bei Netzen, deren Stempunkt über einen Widerstand mit Erde verbunden ist, sowie bei isolierten Netzen, also bei Netzen mit isoliertem Sternpunkt, angewandt werden. Die Resonanzabstimmung der Löschspule entfällt in diesem Fall natürlich.

**Patentansprüche**

1. Verfahren zur Bestimmung mindestens eines Parameters eines elektrischen Netzes oder eines Nullsystems des elektrischen Netzes oder eines Leitungsabschnittes oder Leitungsabzweiges des elektrischen Netzes, insbesondere der Nulladmittanz $Y$, der Phasensumme der Leitwerte der ohmschen Ableitungen $g$ und/oder der Phasensumme der Ableitkapazitäten $C$ sowie des Unsymmetriestroms $i_v$, wobei in einen Netzsternpunkt oder in das Nullsystem des elektrischen Netzes, vorzugsweise eines elektrisches Netzes mit induktiv oder über ohmschen Widerstand geerdetem oder isoliertem Sternpunkt, zumindest zeitweise ein Hilfssignal mit einer Kreisfrequenz $\omega_i$ ungleich der Netzkreisfrequenz $\omega_N$ und ungleich deren ganzzahlig ungeradzahligen Vielfachen eingespeist wird, **dadurch gekennzeichnet, dass** der zumindest eine Parameter aus dem Nullstrom $i_0$ und der Verlagerungsspannung $U_{ne}$ bezüglich der gewählten Einspeisekreisfrequenz $\omega_i$ ermittelt wird.

2. Verfahren nach Anspruch 1, **dadurch gekennzeichnet, dass** als Parameter die Nulladmittanz $Y$ als komplexer Quotient aus den Spektralanteilen des Nullstroms $i_0$ und der Verlagerungsspannung $U_{ne}$ bezüglich der Einspeisekreisfrequenz $\omega_i$ und/oder die Phasensumme der Leitwerte der ohmschen Ableitungen $g$ als Realteil dieses Quotienten und/oder die Phasensumme der Ableitkapazitäten $C$ als Imaginärteil dieses Quotienten, gemäß den Beziehungen

$$g = \mathrm{Re}[Y(j\varpi_i)] = \mathrm{Re}\left[\frac{i_0(j\varpi_i)}{U_{ne}(j\varpi_i)}\right] \text{ und } C = \frac{1}{\varpi_i}\mathrm{Im}[Y(j\varpi_i)] = \frac{1}{\varpi_i}\mathrm{Im}\left[\frac{i_0(j\varpi_i)}{U_{ne}(j\varpi_i)}\right],$$

oder durch andere geeignete hinlänglich bekannte äquivalente Methoden, beispielsweise durch Methoden im Zeitbereich, Koeffizientenschätzverfahren oder durch Methoden der frequenzselektiven Vorfilterung, ermittelt werden/ wird.

3. Verfahren nach Anspruch 1 oder 2, **dadurch gekennzeichnet, dass** als Parameter der Unsymmetriestrom $i_v$ be-

züglich der Netzkreisfrequenz $\omega_N$ des elektrischen Netzes anhand der Beziehung

$$i_v(j\bar{\omega}_N) = i_0(j\bar{\omega}_N) - U_{ne}(j\bar{\omega}_N) \cdot Y(j\bar{\omega}_N)$$

mit

$$Y(j\omega_N) = g + j\bar{\omega}_N C$$

ermittelt wird.

4. Verfahren nach Anspruch 2, **dadurch gekennzeichnet, dass** für einen (n)-ten Leitungsabschnitt bzw. Leitungsabzweig des elektrischen Netzes die Abschnittsnulladmittanz $Y(n,j\omega_i)$ und/oder zumindest ein darin enthaltener Abzweigparameter $g(n)$, $C(n)$ anhand des Nullstromes $i_0$ dieses (n)-ten Leitungsabschnittes bzw. Leitungsabzweiges und der Verlagerungsspannung $U_{ne}$ des Netzes bezüglich der Einspeisekreisfrequenz $\omega_i$ gemäß den Beziehungen

$$g(n) = \mathrm{Re}\left[Y(n, j\varpi_i)\right] = \mathrm{Re}\left[\frac{i_0(n, j\varpi_i)}{U_{ne}(j\varpi_i)}\right]$$

und

$$C(n) = \frac{1}{\varpi_i} \mathrm{Im}\left[Y(n, j\varpi_i)\right] = \frac{1}{\varpi_i} \mathrm{Im}\left[\frac{i_0(n, j\varpi_i)}{U_{ne}(j\varpi_i)}\right],$$

oder durch andere geeignete hinlänglich bekannte äquivalente Methoden, beispielsweise durch Methoden im Zeitbereich, Koeffizientenschätzverfahren oder durch Methoden der frequenzselektiven Vorfilterung, ermittelt werden/wird.

5. Verfahren nach Anspruch 3, **dadurch gekennzeichnet, dass** für einen (n)-ten Leitungsabschnitt bzw. Leitungsabzweig des elektrischen Netzes der Unsymmetriestrom $i_v(n,j\bar{\omega}_N)$ anhand des Nullstromes $i_0$ dieses (n)-ten Leitungsabschnittes bzw. Leitungsabzweiges und der Verlagerungsspannung $U_{ne}$ des Netzes bezüglich der Netzkreisfrequenz $\omega_N$ gemäß der Beziehung $i_v(n,j\bar{\omega}_N) = i_0(n,j\bar{\omega}_N) - U_{ne}(j\bar{\omega}_N) \cdot Y(n,j\bar{\omega}_N)$ mit $Y(n,j\omega_N) = g(n) + j\bar{\omega}_N C(n)$, oder durch andere geeignete hinlänglich bekannte äquivalente Methoden, beispielsweise durch Methoden im Zeitbereich, Koeffizientenschätzverfahren oder durch Methoden der frequenzselektiven Vorfilterung, ermittelt wird.

6. Verfahren nach einem der Ansprüche 2 bis 5, **dadurch gekennzeichnet, dass** für das Gesamtnetz die Summennulladmittanz $Y_S(j\omega_i)$ und/oder zumindest ein darin enthaltener Netzparameter, wie Summenleitwert $g_S$ und/oder Summenableitkapazität $C_S$ anhand des Summennullstromes $i_{0S}$ und der Verlagerungsspannung $U_{ne}$ des Netzes bezüglich der Einspeisekreisfrequenz $\omega_i$ gemäß den Beziehungen

$$g_S = \mathrm{Re}\left[Y_S(j\varpi_i)\right] = \mathrm{Re}\left[\frac{i_{0S}(j\varpi_i)}{U_{ne}(j\varpi_i)}\right]$$

und

$$C_S = \frac{1}{\varpi_i} \mathrm{Im}\left[Y_S(j\varpi_i)\right] = \frac{1}{\varpi_i} \mathrm{Im}\left[\frac{i_{0S}(j\varpi_i)}{U_{ne}(j\varpi_i)}\right],$$

oder durch andere geeignete hinlänglich bekannte äquivalente Methoden, beispielsweise durch Methoden im Zeitbereich, Koeffizientenschätzverfahren oder durch Methoden der frequenzselektiven Vorfilterung, ermittelt werden/wird.

7.  Verfahren nach einem der Ansprüche 3 bis 6, **dadurch gekennzeichnet, dass** für das Gesamtnetz der Summenunsymmetriestrom $i_{vS}$ anhand des Summennullstromes $i_{0S}$ und der Verlagerungsspannung $U_{ne}$ des Netzes bezüglich der Netzkreisfrequenz $\omega_N$ gemäß der Beziehung $i_{vS}(j\bar{\omega}_N) = i_{0S}(j\bar{\omega}_N) - U_{ne}(j\bar{\omega}_N) \cdot Y_S(j\bar{\omega}_N)$ mit $Y_S(j\omega_N) = g_S + j\bar{\omega}_N C_S$, oder durch andere geeignete hinlänglich bekannte äquivalente Methoden, beispielsweise durch Methoden im Zeitbereich, Koeffizientenschätzverfahren oder durch Methoden der frequenzselektiven Vorfilterung, ermittelt wird.

8.  Verfahren nach Anspruch 4, **dadurch gekennzeichnet, dass** zumindest ein Netzparameter des Gesamtnetzes, Summenleitwert $g_S$ und/oder Summenableitkapazität $C_S$, durch Aufsummieren der einzelnen Abzweigparameter $g(n)$, $C(n)$ ermittelt wird.

9.  Verfahren nach Anspruch 5, **dadurch gekennzeichnet, dass** der Summenunsymmetriestrom $i_{vS}$, durch Aufsummieren des Abzweigparameters $i_v(n,j\bar{\omega}_N)$ ermittelt wird.

10. Verfahren nach einem der Ansprüche 1 bis 9, **dadurch gekennzeichnet, dass** die Parameter anhand der Spektralanteile der Fouriertransformierten, vorzugsweise Fast Fouriertransformierten oder diskreten Fouriertransformierten, des Nullstromes $i_0$ und der Verlagerungsspannung $U_{ne}$ bezüglich der Einspeisekreisfrequenz $\omega_i$ ermittelt werden.

11. Verfahren nach Anspruch 6 oder 8, **dadurch gekennzeichnet, dass** der Summenleitwert $g_S$ zur Ermittlung des Wattreststromes mit dem Effektivwert der Phasennennspannung multipliziert wird.

12. Verfahren nach Anspruch 6 oder 8 für ein Netz mit einer Löschspule, **dadurch gekennzeichnet, dass** die Summenableitkapazität $C_S$ zur Ermittlung des Löschspulenresonanzstromes mit dem Effektivwert der Phasennennspannung und der Netzkreisfrequenz $\omega_N$ multipliziert wird.

13. Verfahren nach einem der Ansprüche 1 bis 12, **dadurch gekennzeichnet, dass** als Parameter die Nulladmittanz Y, die Phasensumme der Leitwerte der ohmschen Ableitungen g, die Phasensumme der Ableitkapazitäten C und/oder der Unsymmetriestrom $i_v$ ermittelt werden/wird und diese/dieser Parameter zur Ortung von Erdfehlern, Erkennung und Lokalisierung von Schalthandlungen im Netz und/oder zur Abstimmung einer Löschspule verwendet werden/wird.

14. Verfahren nach Anspruch 13, **dadurch gekennzeichnet, dass** als Parameter die Nulladmittanz Y ermittelt wird und ein Erdfehler erkannt und gegebenenfalls angezeigt wird, wenn der Realteil oder die Realteiländerung der Nulladmittanz $Y$ für eine vorgegebene Zeitspanne eine vorgegebene Fehlerschwelle überschreitet.

15. Verfahren nach Anspruch 14, **dadurch gekennzeichnet, dass** das Ende eines Fehlerzustandes erkannt und gegebenenfalls angezeigt wird, wenn für den Realteil oder die Realteiländerung die vorgegebene Fehlerschwelle für eine vorgegebene Zeitspanne wieder unterschritten wird.

16. Verfahren nach Anspruch 13, **dadurch gekennzeichnet, dass** als Parameter die Nulladmittanz Y ermittelt wird und eine Schalthandlung im Gesamtnetz oder innerhalb eines Leitungsabschnittes bzw. -abzweiges erkannt und gegebenenfalls angezeigt wird, wenn der Imaginärteil bzw. die Imaginärteiländerung der Nulladmittanz $Y$ für eine vorgegebene Zeitspanne eine vorgegebene Fehlerschwelle überschreitet.

17. Verfahren nach Anspruch 13, **dadurch gekennzeichnet, dass** die Fehlerhaftigkeit eines Leitungsabschnittes oder -abzweiges mittels der im fehlerfreien Netzzustand ermittelten Abzweigparameter $g(n)$, $C(n)$ und $i_v(n)$ bestimmt wird.

18. Verfahren nach Anspruch 17, **dadurch gekennzeichnet, dass**

a) die Abzweigparameter Abschnittsteitwert $g(n)$, Abschnittsableitkapazität $C(n)$ und Abschnittsunsymmetriestrom $i_v(n,j\bar{\omega}_N)$ zumindest eines Leitungsabschnittes bzw. Leitungsabzweiges in bestimmten zeitlichen Abständen während des fehlerfreien Netzzustandes ermittelt werden,

b) die derart ermittelten Werte, gegebenenfalls nach Mittelung mit vorangegangenen Werten, als Referenzwerte $i_{vREF}(n,j\bar{\omega}_N)$, $g_{REF}(n)$ und $C_{REF}(n)$ in einen Referenzwertspeicher abgelegt werden,
c) beim Erkennen eines Erdfehlers die Aktualisierung des Referenzwertspeichers unterbrochen wird,
d) ein Fehlerstrom $i_f(n,j\bar{\omega}_N)$ gemäß der Beziehung

$$i_f(n,j\omega_N) = i_0(n,j\omega_N) - [U_{ne}(j\omega_N)\,Y_{REF}(n,j\omega_N)] - i_{vREF}(n,j\omega_N)$$

mit

$$Y_{REF}(n,j\omega_N) = g_{REF}(n) + j\bar{\omega}_N C_{REF}(n),$$

oder durch äquivalente, hinlänglich bekannte Methoden, ermittelt wird und
e) der Leitungsabschnitt bzw. -abzweig als fehlerhaft erkannt und gegebenenfalls angezeigt wird, wenn der Betrag des so ermittelten Fehlerstromes $i_f(n,j\bar{\omega}_N)$ für eine vorgegebene Zeit eine vorgegebene Fehlerstromschwelle überschreitet.

**19.** Verfahren nach Anspruch 18, **dadurch gekennzeichnet, dass** der auf ein Netzreferenzsignal bezogene Phasenwinkel des Fehlerstromes $i_f(n,j\bar{\omega}_N)$ mit den auf das gleiche Netzreferenzsignal bezogenen Phasenwinkeln der Phasen-Erdspannungen verglichen wird und jene Phase als fehlerhaft erkannt und gegebenenfalls angezeigt wird, deren Phasenwinkel am besten mit dem Phasenwinkel des Fehlerstromes $i_f(n,j\bar{\omega}_N)$ korreliert.

**20.** Verfahren nach Anspruch 18 oder 19, **dadurch gekennzeichnet, dass** nach dem Erkennen der Rückkehr des Netzes in einen fehlerfreien Zustand mit der Aktualisierung der Referenzwerte im Referenzwertspeicher fortgefahren wird.

**21.** Verfahren nach einem der Ansprüche 1 bis 20, **dadurch gekennzeichnet, dass** der Nullstrom $i_0$ des Leitungsabschnittes bzw. -abzweiges bzw. der Summennullstrom $i_{0S}$ und die Verlagerungsspannung $U_{ne}$ gemessen und der Berechnung zugeführt werden.

**22.** Verfahren nach Anspruch 21, **dadurch gekennzeichnet, dass** Momentanwerte des Nullstromes $i_0$ des Leitungsabschnittes bzw. -abzweiges und/oder des Summennullstromes $i_{0S}$ und der Verlagerungsspannung $U_{ne}$ zu zeitlich äquidistanten Zeitpunkten abgetastet, gemessen, in digitale Form gewandelt und in einem digitalen Speicher abgelegt werden.

**23.** Verfahren nach Anspruch 22, **dadurch gekennzeichnet, dass** für jede Messgröße eine Folge mit einer vorgegebenen Anzahl N von aufeinanderfolgend gemessenen und digitalisierten Momentanwerten abgespeichert wird.

**24.** Verfahren nach Anspruch 23, **dadurch gekennzeichnet, dass** die Anzahl N derart gewählt wird, dass die sich daraus ergebende Messzyklusdauer einer jeweils ganzzahligen Anzahl von Periodendauern der Einspeisekreisfrequenz $\omega_i$ und der Netzkreisfrequenz $\omega_N$ entspricht.

**25.** Verfahren nach Anspruch 23 oder 24, **dadurch gekennzeichnet, dass** der Start eines Messzyklus, also N Messungen, mit einem aus einem oder mehreren Phasenspannungen gebildeten Netzreferenzsignal synchronisiert wird.

**26.** Verfahren nach Anspruch 23, 24 oder 25, **dadurch gekennzeichnet, dass** nach einem Messzyklus, also nach N Messungen, die diskreten Spektralanteile des abgetasteten Nullstromsignals $i_0$ des Leitungsabschnittes bzw. -abzweiges und/oder des abgetasteten Summennullstromsignals $i_{0S}$ und des abgetasteten Verlagerungsspannungssignals $U_{ne}$ bezüglich zumindest der Einspeisekreisfrequenz $\omega_i$ und der Netzkreisfrequenz $\omega_N$, vorzugsweise mit der Fast Fourier Transformation oder der diskreten Fourier Transformation, ermittelt werden und daraus zumindest einer der Parameter $g$ , $C$ oder $i_v$, berechnet wird.

**Claims**

**1.** Method for determining at least one parameter of an electrical network or a zero phase-sequence system of the electrical network or a line section or a line branch of the electrical network, especially the zero phase-sequence admittance $Y$, the phase sum of the conductances of the ohmic terminal lines $g$ and/or the phase sum of the terminal capacitances $C$ and of the unbalance current $i_v$, an auxiliary signal with an angular frequency $\omega_i$ other than the network angular frequency $\omega_N$ and other than its odd integer multiples being injected at least temporarily into a network neutral point or into the zero phase-sequence system of the electrical network, preferably of an electrical network with a neutral point earthed or isolated inductively or via an ohmic impedance, **characterised in that** the at least one parameter is found from the zero phase-sequence current $i_0$ and the displacement voltage $U_{ne}$ with respect to the selected injection angular frequency $\omega_i$.

2. Method according to Claim 1, **characterised in that**, as parameters, the zero phase-sequence admittance $Y$ is found as a complex ratio of the spectral components of the zero phase-sequence current $i_0$ and the displacement voltage $U_{ne}$ with respect to the injection angular frequency $\omega_i$ and/or the phase sum of the conductances of the ohmic terminal lines $g$ is found as the real part of this ratio and/or the phase sum of the terminal capacitances $C$ is found as the imaginary part of this ratio, according to the relations

$$g \;=\; \mathrm{Re}[Y(j\widetilde{\omega}_i)] = \mathrm{Re}\left[\frac{i_0(j\widetilde{\omega}_i)}{U_{ne}(j\widetilde{\omega}_i)}\right] \;\; \text{and} \;\; C \;=\frac{1}{\widetilde{\omega}_i}\,\mathrm{Im}[Y(j\widetilde{\omega}_i)] = \frac{1}{\widetilde{\omega}_i}\,\mathrm{Im}\left[\frac{i_0(j\widetilde{\omega}_i)}{U_{ne}(j\widetilde{\omega}_i)}\right],$$

or by other well-known suitable equivalent methods, for example methods in the time domain, coefficient estimation methods or methods of frequency selective prefiltering.

3. Method according to Claim 1 or 2, **characterised in that** the unbalance current $i_v$ with respect to the network angular frequency $\omega_N$ of the electrical network is found as the parameter with the aid of the relation

$$i_v(j\widetilde{\omega}_N) = i_0(j\widetilde{\omega}_N) - U_{ne}(j\widetilde{\omega}_N)\cdot Y(j\widetilde{\omega}_N)$$

with

$$Y(j\widetilde{\omega}_N) = g + j\widetilde{\omega}_N C\;.$$

4. Method according to Claim 2, **characterised in that** for an (n)$^{\text{th}}$ line section or line branch of the electrical network, the section zero phase-sequence admittance $Y(n,j\omega_i)$ and/or at least one branch parameter $g(n)$, $C(n)$ contained in it is/are found with the aid of the zero phase-sequence current $i_0$ of this (n)$^{\text{th}}$ line section or line branch and the displacement voltage $U_{ne}$ of the network with respect to the injection angular frequency $\omega_i$ according to the relations

$$g(n) \;=\; \mathrm{Re}[Y(n,j\widetilde{\omega}_i)] = \mathrm{Re}\left[\frac{i_0(n,j\widetilde{\omega}_i)}{U_{ne}(j\widetilde{\omega}_i)}\right]$$

and

$$C(n) \;=\frac{1}{\widetilde{\omega}_i}\,\mathrm{Im}[Y(n,j\widetilde{\omega}_i)] = \frac{1}{\widetilde{\omega}_i}\,\mathrm{Im}\left[\frac{i_0(n,j\widetilde{\omega}_i)}{U_{ne}(j\widetilde{\omega}_i)}\right],$$

or by other well-known suitable equivalent methods, for example methods in the time domain, coefficient estimation methods or methods of frequency selective prefiltering.

5. Method according to Claim 3, **characterised in that** for an $(n)^{th}$ line section or line branch of the electrical network, the unbalance current $i_v(n,j\widetilde{\omega}_N)$ is found with the aid of the zero phase-sequence current $i_0$ of this $(n)^{th}$ line section or line branch and the displacement voltage $U_{ne}$ of the network with respect to the network angular frequency $\omega_N$ according to the relation

$$i_v(n,j\widetilde{\omega}_N)=i_0(n,j\widetilde{\omega}_N)-U_{ne}(j\widetilde{\omega}_N)\cdot Y(n,j\widetilde{\omega}_N) \quad \text{with} \quad Y(n,j\widetilde{\omega}_N)=g(n)+j\widetilde{\omega}_N C(n),$$

or by other well-known suitable equivalent methods, for example methods in the time domain, coefficient estimation methods or methods of frequency selective prefiltering.

6. Method according to one of Claims 2 to 5, **characterised in that** for the overall network, the zero phase-sequence admittance sum $Y_S(j\omega_i)$ and/or at least one network parameter contained in it, such as the conductance sum $g_S$ and/or the terminal capacitance sum $C_S$, is/are found with the aid of the zero phase-sequence current sum $i_{0S}$ and the displacement voltage $U_{ne}$ of the network with respect to the injection angular frequency $\omega_i$ according to the relations

$$g_S \ = \ \operatorname{Re}[Y_S(j\widetilde{\omega}_i)]=\operatorname{Re}\left[\frac{i_{0S}(j\widetilde{\omega}_i)}{U_{ne}(j\widetilde{\omega}_i)}\right]$$

and

$$C_S \ =\frac{1}{\widetilde{\omega}_i}\operatorname{Im}[Y_S(j\widetilde{\omega}_i)]=\frac{1}{\widetilde{\omega}_i}\operatorname{Im}\left[\frac{i_{0S}(j\widetilde{\omega}_i)}{U_{ne}(j\widetilde{\omega}_i)}\right],$$

or by other well-known suitable equivalent methods, for example methods in the time domain, coefficient estimation methods or methods of frequency selective prefiltering.

7. Method according to one of Claims 3 to 6, **characterised in that** for the overall network, the unbalance current sum $i_{vS}$ is found with the aid of the zero phase-sequence current sum $i_{0S}$ and the displacement voltage $U_{ne}$ of the network with respect to the network angular frequency $\omega_N$ according to the relation

$$i_{vS}(j\widetilde{\omega}_N)=i_{0S}(j\widetilde{\omega}_N)-U_{ne}(j\widetilde{\omega}_N)\cdot Y_S(j\widetilde{\omega}_N) \quad \text{with} \quad Y_S(j\widetilde{\omega}_N)=g_S+j\widetilde{\omega}_N C_S,$$

or by other well-known suitable equivalent methods, for example methods in the time domain, coefficient estimation methods or methods of frequency selective prefiltering.

8. Method according to Claim 4, **characterised in that** at least one network parameter of the overall network: conductance sum $g_S$ and/or terminal capacitance sum $C_S$ is found by summation of the individual branch parameters $g(n), C(n)$.

9. Method according to Claim 5, **characterised in that** the unbalance current sum $i_{vS}$ is found by summation of the branch parameters $i_v(n,j_N)$.

10. Method according to one of Claims 1 to 9, **characterised in that** the parameters are found with the aid of the spectral components of the Fourier transform, preferably fast Fourier transform or discrete Fourier transform, of the zero phase-sequence current $i_0$ and of the displacement voltage $U_{ne}$ with respect to the injection angular frequency $\omega_i$.

11. Method according to Claim 6 or 8, **characterised in that** the conductance sum $g_S$ is multiplied by the rms value of the rated phase voltage in order to find the residual ohmic current.

**12.** Method according to Claim 6 or 8 for a network having a suppression coil, **characterised in that** the terminal capacitance sum $C_S$ is multiplied by the rms value of the rated phase voltage and the network angular frequency $\omega_N$ in order to find the suppression coil resonance current.

**13.** Method according to one of Claims 1 to 12, **characterised in that** the zero phase-sequence admittance Y, the phase sum of the conductances of the ohmic terminal lines g, the phase sum of the terminal capacitances C and/or the unbalance current $i_v$ is/are found as parameters, and this/these parameters is/are used in order to locate earth faults, identify and locate switching actions in the network and/or in order to tune a suppression coil.

**14.** Method according to Claim 13, **characterised in that** the zero phase-sequence admittance Y is determined as the parameter, and an earth fault is identified and optionally displayed if the real part or the real part variation of the zero phase-sequence admittance Y exceeds a predetermined fault threshold for a predetermined period of time.

**15.** Method according to Claim 14, **characterised in that** the end of a fault status is identified and optionally displayed if the real part or the real part variation falls back below its predetermined fault threshold for a predetermined period of time.

**16.** Method according to Claim 13, **characterised in that** the zero phase-sequence admittance Y is determined as the parameter, and a switching action in the overall network or inside a line section or branch is identified and optionally displayed if the imaginary part or the imaginary part variation of the zero phase-sequence admittance Y exceeds a predetermined fault threshold for a predetermined period of time.

**17.** Method according to Claim 13, **characterised in that** the faultiness of a line section or branch is determined by means of the branch parameters $g(n)$, $C(n)$ and $i_v(n)$ found in the fault-free network status.

**18.** Method according to Claim 17, **characterised in that**

a) the branch parameters: section conductance $g(n)$, section terminal capacitance $C(n)$ and section unbalance current $i_v(n,j\widetilde{\omega}_N)$ of at least one line section or line branch are found at particular time intervals during the fault-free network status,
b) the values found in this way are stored as reference values $i_{vREF}(n,j\widetilde{\omega}_N)$, $g_{REF}(n)$ and $C_{REF}(n)$ in a reference value memory, optionally after averaging with previous values,
c) the updating of the reference value memory is suspended when an earth fault is identified,
d) a fault current $i_f(n,j\widetilde{\omega}_N)$ is found according to the relation

$$i_f(n,j\omega_N) = i_0(n,j\omega_N) - [U_{ne}(j\omega_N)Y_{REF}(n,j\omega_N)] - i_{VREF}(n,j\omega_N)$$

with

$$Y_{REF}(n,j\omega_N) = g_{REF}(n) + j\widetilde{\omega}_N C_{REF}(n),$$

or by well-known equivalent methods, and
e) the line section or branch is identified as faulty and optionally displayed if the magnitude of the fault current $i_f(n,j\widetilde{\omega}_N)$ found in this way exceeds a predetermined fault current threshold for a predetermined time.

**19.** Method according to Claim 18, **characterised in that** the phase angle of the fault current $i_f(n,j\widetilde{\omega}_N)$ relative to a network reference signal is compared with the phase angles of the phase-to-earth voltages with respect to the same network reference signal, and the phase whose phase angle correlates best with the phase angle of the fault current $i_f(n,j\widetilde{\omega}_N)$ is identified as faulty and optionally displayed.

**20.** Method according to Claim 18 or 19, **characterised in that** the updating of the reference values in the reference value memory is resumed after the return of the network to a fault-free status is identified.

**21.** Method according to one of Claims 1 to 20, **characterised in that** the zero phase-sequence current $i_0$ of the line section or branch or the zero phase-sequence current sum $i_{0S}$ and the displacement voltage $U_{ne}$ are measured and put into the calculation.

**22.** Method according to Claim 21, **characterised in that** the instantaneous values of the zero phase-sequence current $i_0$ of the line section or branch and/or of the zero phase-sequence current sum $i_{0S}$ and the displacement voltage $U_{ne}$ are sampled or measured at chronologically equidistant instants, converted into digital form and stored in a digital memory.

**23.** Method according to Claim 22, **characterised in that** a sequence with a predetermined number N of successively measured and digitised instantaneous values is stored for each measurement quantity.

**24.** Method according to Claim 23, **characterised in that** the number N is selected so that the resulting measurement cycle duration corresponds to a respective integer number of periods of the injection angular frequency $\omega_i$ and of the network angular frequency $\omega_N$.

**25.** Method according to Claim 23 or 24, **characterised in that** the start of a measurement cycle, i.e. N measurements, is synchronised with a network reference signal formed from one or more phase voltages.

**26.** Method according to Claim 23, 24 or 25, **characterised in that** the discrete spectral components of the sampled zero phase-sequence current signal $i_0$ of the line section or branch and/or of the sampled zero phase-sequence current sum signal $i_{0S}$ and the sampled displacement voltage signal $U_{ne}$ with respect to at least the injection angular frequency $\omega_i$ and the network angular frequency $\omega_N$ are found after a measurement cycle, i.e. N measurements, preferably by fast Fourier transform or discrete Fourier transform, and at least one of the parameters $g$, $C$ or $i_v$ is calculated therefrom.

**Revendications**

**1.** Procédé pour déterminer un paramètre d'un réseau électrique, ou d'un système neutre du réseau électrique, ou d'un tronçon de ligne ou d'une ramification de ligne du réseau électrique, en particulier de l'admittance nulle Y, la somme des phases des conductances des dérivations ohmiques g et/ou de la somme des phases des capacités de dérivation C, ainsi que du courant d'asymétrie $i_v$ sachant que, en un point neutre du réseau ou dans le système neutre du réseau électrique, de préférence d'un réseau électrique mis à la terre avec une résistance inductive ou par une résistance ohmique, ou bien d'un point neutre isolé, au moins par moments un signal auxiliaire, ayant une fréquence angulaire $\omega_i$ différente de la fréquence angulaire du réseau $\omega_N$ et différente de ses multiples impairs à nombre entier est injecté, **caractérisé en ce que** le au moins un paramètre est déterminé à partir du courant neutre $i_0$ et de la tension de décalage $U_{ne}$ par rapport à la fréquence angulaire d'injection $\omega_i$ choisie.

**2.** Procédé selon la revendication 1, **caractérisé en ce que**, à titre de paramètre, est/sont déterminée(s) l'admittance neutre Y, sous forme de quotient complexe à partir des proportions spectrales du courant neutre $i_0$ et de la tension de décalage $U_{ne}$ par rapport à la fréquence angulaire d'injection $\omega_i$, et/ou la somme des phases de conductance des dérivations g ohmiques, en tant que partie réelle de ce quotient et/ou la somme des phases des capacités de dérivation C, en tant que partie imaginaire de ce quotient, selon les relations :

$$g = \mathrm{Re}\left[Y(j\varpi_i)\right] = \mathrm{Re}\left[\frac{i_0(j\varpi_i)}{U_{ne}(j\varpi_i)}\right] \ \text{ et } \ \ C = \frac{1}{\varpi_i} \ = \ \mathrm{Im}\left[Y(j\varpi_i)\right] \ = \ \frac{1}{\varpi_i} \ \mathrm{Im}\left[\frac{i_0(j\varpi_i)}{U_{ne}(j\varpi_i)}\right],$$

ou bien par d'autres méthodes équivalentes, connues depuis longtemps, appropriées, par exemple par des méthodes opérant dans le domaine des temps, des procédés d'estimation de coefficient et/ou par des méthodes de préfiltrage à sélectivité de fréquence.

**3.** Procédé selon la revendication 1 ou 2, **caractérisé en ce qu'**on détermine comme paramètre du courant d'asymétrie $i_v$ par rapport à la fréquence angulaire de réseau $\omega_n$ du réseau électrique à l'aide de la relation

$$i_v(j\overline{\omega}_N) = i_0(j\overline{\omega}_N) - U_{ne}(j\overline{\omega}_N) . Y(j\overline{\omega}_N)$$

avec

$$Y(j\omega_N) = g + j\overline{\omega}_N C.$$

**4.** Procédé selon la revendication 2, **caractérisé en ce que** pour un (n)ième tronçon de ligne ou ramification de ligne du réseau électrique, on détermine l'admittance neutre de tronçon $Y(n,j\omega_i)$ et/ou au moins un paramètre de ramification g(n), C(n), y étant contenu, à l'aide du courant neutre $i_0$ de ce (n)ième tronçon de ligne ou ramification de ligne et de la tension de décalage $U_n$ du réseau par rapport à la fréquence angulaire d'injection $\omega_i$ suivant les relations :

$$g = \text{Re}[Y(n,j\varpi_i)] = \text{Re}\left[\frac{i_0(n,j\varpi_i)}{U_{ne}(j\varpi_i)}\right]$$

et

$$C = \frac{1}{\varpi_i} = \text{Im}[Y(n,j\varpi_i)] = \frac{1}{\varpi_i} \text{Im}\left[\frac{i_0(n,j\varpi_i)}{U_{ne}(j\varpi_i)}\right],$$

ou par d'autres méthodes appropriées, équivalentes, connues depuis longtemps, par exemple par des méthodes opérant dans le domaine des temps, des procédés d'estimation de coefficient ou par des méthodes de préfiltrage à sélectivité de fréquence.

**5.** Procédé selon la revendication 3, **caractérisé en ce que**, pour un (n)ième tronçon de ligne ou ramification de ligne du réseau électrique, on détermine le courant d'asymétrie $i_v(n,j\overline{\omega}_i)$, à l'aide du courant neutre $I_0$ de ce (n) ième tronçon de ligne ou ramification de ligne et de la tension de décalage $U_{ne}$ du réseau par rapport à la fréquence angulaire de réseau $\omega_N$, selon la relation

$$i_v(n,j\overline{\omega}_N) = i_o(n,j\overline{\omega}_N) - U_{ne}(j\overline{\omega}_N) . Y(n,j\overline{\omega}_N), \qquad \text{avec} \qquad Y(n,j\omega_N) = g(n) + j\overline{\omega}_N C(n),$$

ou bien par d'autres méthodes appropriées, équivalentes, connues depuis longtemps, par exemple par des méthodes opérant dans le domaine des temps, des procédés d'estimation de coefficient ou par des méthodes de préfiltrage à sélectivité de fréquence.

**6.** Procédé selon l'une des revendications 2 à 5, **caractérisé en ce que**, pour le réseau global, est/sont déterminée(s) l'admittance neutre de somme $Y_s(j\omega_i)$ et/ou au moins un paramètre de réseau y étant contenu, tel que la conductance de somme $g_s$ et/ou la capacité de dérivation de somme $C_s$, à l'aide du courant neutre de somme $i_{os}$ et de la tension de décalage $U_{ne}$ du réseau par rapport à la fréquence angulaire d'injection $\omega_i$, selon les relations :

$$g_s = \text{Re}[Y_s(j\varpi_i)] = \text{Re}\left[\frac{i_{os}(j\varpi_i)}{U_{ne}(j\varpi_i)}\right] \quad \text{et} \quad C_s = \frac{1}{\varpi_i} = \text{Im}[Y_s(j\varpi_i)] = \frac{1}{\varpi_i} \text{Im}\left[\frac{i_{os}(j\varpi_i)}{U_{ne}(j\varpi_i)}\right],$$

ou bien par d'autres méthodes appropriées équivalentes, connues depuis longtemps, par exemple par des méthodes opérant dans le domaine des temps, des procédés d'estimation de coefficient ou par des méthodes de préfiltrage à sélectivité de fréquence.

**7.** Procédé selon l'une des revendications 3 à 6, **caractérisé en ce que** pour le réseau global, on détermine le courant d'asymétrie de somme $i_{vS}$ à l'aide du courant neutre de somme $i_{OS}$ et du courant de la tension de décalage $U_{ne}$ du réseau par rapport à la fréquence angulaire de réseau $\omega_N$, selon la relation :

$$i_{vS}(j\bar{\omega}_N) = i_{OS}(j\bar{\omega}_N) - U_{ne}(j\bar{\omega}_N).Y_S(j\bar{\omega}_N) \text{ avec } Y_S(j\omega_N) = g_s + j\bar{\omega}_N C_S$$

ou bien par d'autres méthodes équivalentes, appropriées, connues depuis longtemps, par exemple par des méthodes opérant dans le domaine des temps, des procédés d'estimation de coefficient ou par des méthodes de préfiltrage à sélectivité de fréquence.

8. Procédé selon la revendication 4, **caractérisé en ce qu'**au moins un paramètre de réseau du réseau global, une conductance de somme $g_S$ et/ou une capacité de dérivation de somme $C_S$ est déterminée par sommation des différents paramètres de ramification g(n), C(n).

9. Procédé selon la revendication 5, **caractérisé en ce que** le courant d'asymétrie de somme $i_{vs}$ est déterminé par sommation du paramètre de ramification $i_v(n,j\bar{\omega}_N)$.

10. Procédé selon l'une des revendications 1 à 9, **caractérisé en ce que** les paramètres sont déterminés à l'aide des proportions spectrales de la transformée de Fourier, de préférence, de la transformée de Fourier Rapide, ou bien de transformée de Fourier Discrète, du courant neutre $i_0$ et de la tension de décalage $U_{ne}$ par rapport à la fréquence angulaire d'injection $\bar{\omega}_i$.

11. Procédé selon les revendications 6 ou 7, **caractérisé en ce que** la conductivité de somme $g_s$ pour déterminer le courant résiduel de Watt est multipliée par la valeur efficace de la tension nominale de phase.

12. Procédé selon les revendications 6 ou 8 pour un réseau, avec une bobine d'extinction, **caractérisé en ce que** la capacité de déviation de somme $C_S$ pour déterminer le courant de résonance de bobine d'extinction est multipliée avec la valeur efficace de la tension nominale de phase et de la fréquence angulaire de réseau $\omega_N$.

13. Procédé selon l'une des revendications 1 à 12, **caractérisé en ce que**, en tant que paramètre(s), est/sont déterminée(s) l'admittance neutre Y, la somme des phases des conductances des dérivations ohmiques g, la somme des phases des capacités de dérivation C et/ou le courant d'asymétrie $i_v$ et ce/ces paramètre(s) est/sont déterminé (s) pour localiser des défauts à la terre, identifier et localiser des manipulations de commutation dans le réseau et/ou accorder une bobine de soufflage.

14. Procédé selon la revendication 13, **caractérisé en ce qu'**on détermine comme paramètre l'admittance neutre Y et on identifie un défaut à la terre et, le cas échéant, on l'affiche, lorsque la partie réelle ou la variation de partie réelle de l'admittance neutre Y dépasse une valeur de seuil prédéterminée, pendant un intervalle de temps prédéterminé.

15. Procédé selon la revendication 14, **caractérisé en ce que** la fin d'un état de défaut est identifiée et, le cas échéant, affichée si, pour la partie réelle ou une variation de partie réelle, on descend en dessous du seuil de défaut prédéterminé, de nouveau, pendant un intervalle de temps prédéterminé.

16. Procédé selon la revendication 13, **caractérisé en ce qu'**on détermine comme paramètre l'admittance neutre Y et on identifie une manipulation de commutation dans le réseau global, ou à l'intérieur d'un tronçon ou d'une dérivation de ligne et, le cas échéant, on l'affiche, si la partie imaginaire ou la variation de partie imaginaire de l'admittance neutre Y dépasse un seuil d'erreur prédéterminé pour un intervalle de temps prédéterminé.

17. Procédé selon la revendication 13, **caractérisé en ce que** la teneur en défauts d'un tronçon ou d'une ramification de ligne est déterminée au moyen des paramètres de ramification g(n), C(n) et $i_v(n)$, déterminés à l'état de réseau exempt de défauts.

18. Procédé selon la revendication 17, **caractérisé en ce que** :

a) les paramètres de ramification, la conductance de tronçon g(n), la capacité de dérivation de tronçon C(n) et le courant d'asymétrie de tronçon $i_v(n,j\bar{\omega}_N)$, au moins d'un tronçon de ligne ou d'une ramification de ligne, sont déterminés à des intervalles de temps déterminés pendant l'état de réseau sans défaut,

b) les valeurs déterminées de cette manière, le cas échéant après formation de la moyenne avec des valeurs précédentes, sont placées, en tant que valeurs de référence $i_{vREF}(n,j\overline{\omega}_N)$, $g_{REF}(n)$ et $C_{REF}(n)$, dans une mémoire de valeur de référence,

c) l'actualisation de la mémoire de valeur de référence est interrompue à l'identification d'un défaut à la terre,

d) un courant de défaut $i_f(n,j\overline{\omega}_N)$ est déterminé selon la relation :

$$i_v(n,j\omega_N) = i_0(n,j\omega_N) - [U_{ne}(j\omega_N)Y_{REF}(n,j\omega_N)] - i_{vREF}(n,j\omega_N)$$

avec

$$Y_{REF}(n,j\omega_N) = g_{REF}(n) + j\omega_N\, C_{REF}(n),$$

ou par des méthodes équivalentes, connues depuis longtemps, et

e) le tronçon de ligne ou la ramification de ligne est identifié(e) comme défectueux et, le cas échéant, affiché (e) en tant que tel lorsque la valeur du courant de défaut $i_f(n,j\overline{\omega}_N)$ ainsi déterminé dépasse un seuil de courant de défaut prédéterminé, pendant une durée prédéterminée.

**19.** Procédé selon la revendication 18, **caractérisé en ce que** l'angle de phase, se référant à un signal de fréquence de réseau, du courant de défaut $i_f(n,j\overline{\omega}_N)$ est comparé aux angles de phase, se référant au même signal de référence de réseau, des tensions à la terre de phase, et une phase est identifiée comme défectueuse et, le cas échéant, objet d'affichage si son angle de phase est en corrélation la meilleure avec l'angle de phase du courant de défaut $i_f(n,j\overline{\omega}_N)$.

**20.** Procédé selon la revendication 18 ou 19, **caractérisé en ce que**, après identification, le retour du réseau en un état sans défaut est continué, avec actualisation des valeurs de référence dans la mémoire de valeur de référence.

**21.** Procédé selon l'une des revendications 1 à 20, **caractérisé en ce que** le courant neutre $i_0$ du tronçon de ligne ou de la ramification de ligne ou le courant neutre $i_{0S}$ et la tension de décalage $U_{ne}$ sont mesurés et amenés au calcul.

**22.** Procédé selon la revendication 21, **caractérisé en ce que** des valeurs momentanées du courant neutre $i_0$ du tronçon de ligne ou de la ramification de ligne, et/ou du courant neutre de somme $i_{0S}$ et de la tension de décalage $U_{ne}$ sont scrutées et mesurées à des moments temporellement équidistants, converties sous forme numérique et placées dans une mémoire numérique, à des moments temporellement équidistants.

**23.** Procédé selon la revendication 22, **caractérisé en ce que**, pour chaque grandeur de mesure, est mémorisée une suite, avec un nombre N prédéterminé de valeurs momentanées, mesurées successivement et numérisées.

**24.** Procédé selon la revendication 23, **caractérisé en ce** le nombre N est choisi tel que la durée de cycle de mesure en résultant correspond à un nombre pair respectif de durées de période de la fréquence angulaire d'injection $\omega_i$ et de la fréquence angulaire de réseau $\omega_N$.

**25.** Procédé selon la revendication 23 ou 24, **caractérisé en ce que** le début d'un cycle de mesure, donc de N mesures, est synchronisé avec un signal de référence de réseau, formé d'une ou plusieurs tensions de signal.

**26.** Procédé selon la revendication 23, 24 ou 25, **caractérisé en ce que**, après un cycle de mesure, donc après N mesures, les parties spectrales discrètes du signal de courant neutre $i_0$ scruté du tronçon de ligne ou de ramification de ligne et/ou du signal de courant neutre de somme $i_{0S}$ scruté et du signal de tension de décalage Un scruté, par rapport au moins à la fréquence angulaire d'injection $\omega_i$ et à la fréquence angulaire de réseau $\omega_N$ sont déterminées, de préférence, avec la Transformation de Fourier Rapide ou la Transformation de Fourier Discrète, et l'un des paramètres g, C ou $i_v$ est calculé à partir de cela.

# Fig. 1

# Fig. 2